# EUROPEAN PATENT APPLICATION

(11) **EP 4 770 350 A1**
(43) Date of publication of application: **01.07.2026**
(21) Application number: 24873017.8
(22) Date of filing: 26.09.2024
(51) Int. Cl.: H10H 20/00, H10H 20/812, H10H 20/816, H10H 20/82

(54) **LIGHT-EMITTING ELEMENT AND LIGHT-EMITTING DEVICE COMPRISING SAME**

(30) Priority: 27.09.2023 US 202363585625 P; 25.09.2024 US 202418895844
(71) Applicant: Seoul Viosys Co. Ltd., Ansan-si, Gyeonggi-do 15429 (KR)
(72) Inventor: CHOI, Hyo Shik, Ansan-Si Gyeonggi-do 15429 (KR)
(74) Representative: Stolmár & Partner Patentanwälte PartG mbB
(86) International application number: PCT/KR2024/014669
(87) International publication number: WO 2025/071309

(57) **Abstract**

The disclosed technology discloses a light emitting device, which includes a first window layer doped with a first conductivity type dopant, a second window layer doped with a second conductivity type dopant, and an active layer disposed between the first window layer and the second window layer to generate light, in which the active layer includes at least two quantum barrier layers, at least one quantum well layer, and an aid layer disposed between the quantum well layer and the quantum barrier layer.

## Description

### [Technical Field]

The disclosed technology relates to a light emitting device and a light emitting apparatus having the same.

### [Background Art]

A light emitting diode (LED) is one of the light emitting devices that emit light when current is supplied. Recently, the light emitting diode has found diverse applications in areas such as display apparatuses, vehicle lamps, and general lighting. In addition, the light emitting diode has advantages of longer lifespan, low power consumption, and faster response speed. By making full use of these advantages, it has been quickly replacing the traditional lighting source. As an example, a display apparatus using the light emitting diode may be obtained by forming structures of individually grown red R, green G, and blue B light emitting diodes (LEDs) on a final substrate.

Specifically, the light emitting diode is formed by growing epitaxial layers on a substrate, and includes an n-type semiconductor layer, a p-type semiconductor layer and an active layer interposed therebetween. An n-electrode pad is formed on the n-type semiconductor layer, and a p-electrode pad is formed on the p-type semiconductor layer, so that the light emitting diode is driven by being electrically connected to an external power source through the electrode pads. At this point, current can flow from the p-electrode pad through the semiconductor layers to the n-electrode pad, and light generated through recombination of electrons and holes in the active layer may be emitted. In addition, a light emitting diode with a flip-chip structure has been used to prevent light loss due to the p-electrode pad and to increase heat dissipation efficiency, and various electrode structures have been proposed to aid current distribution in a light emitting diode with a large-area flip-chip structure. In addition to the light emitting diode with the flip-chip structure, various structures such as a vertical type, a lateral type, or others have been used.

Meanwhile, the active layer is an element which generates light, and generally adopts a quantum well structure including a quantum well layer and a quantum barrier layer. In this case, when an energy band gap between the quantum well layer and the quantum barrier layer is too large, a lot of energy is consumed as heat energy while the electrons move to recombine with the holes, resulting in a problem where a radiation efficiency of the active layer is reduced. In addition, when the energy band gap between the quantum well layer and the quantum barrier layer is too small, there is a problem where the radiation efficiency of the active layer is reduced due to a carrier overflow phenomenon.

### [Disclosure]

### [Technical Problem]

The disclosed technology aims to provide a light emitting device and a light emitting apparatus having the same emitting red light with enhanced emission efficiency.

In addition, the disclosed technology aims to provide a light emitting device and a light emitting apparatus having the same that is configured to improve radiation efficiency by reducing heat energy consumption in an active layer and preventing a phenomenon of carrier overflowing.

Moreover, the disclosed technology aims to provide a light emitting device and a light emitting apparatus having the same that is configured to improve reliability ensuring a stable connection between an electrode and a window layer.

### [Technical Solution]

A light emitting device according to an embodiment of the disclosed technology includes a first window layer doped with a first conductivity type dopant, a second window layer doped with a second conductivity type dopant, and an active layer disposed between the first window layer and the second window layer to generate light.

In an embodiment, the active layer may include at least two quantum barrier layers, at least one quantum well layer, and an aid layer disposed between the quantum well layer and the quantum barrier layer.

In an embodiment, an energy band gap of the aid layer may be smaller than an energy band gap of the quantum barrier layer and larger than that of the quantum well layer.

In an embodiment, the quantum barrier layer and the aid layer may include Al and Ga, and an Al composition of the aid layer may be smaller than that of the quantum barrier layer.

In an embodiment, a gradient of an Al composition profile in the aid layer may be different from that of a Ga composition profile.

In an embodiment, a difference between the Al composition of the aid layer and the Al composition of the quantum barrier layer may be greater than or equal to 10%.

In an embodiment, the aid layer may have variable compositions of Al and Ga from an adjacent quantum well layer to an adjacent quantum barrier layer.

In an embodiment, a difference between the Al composition and a Ga composition in the aid layer may increase toward the adjacent quantum well layer.

In an embodiment, the active layer may emit red light.

In an embodiment, a difference between an Al composition of the quantum well layer and the Al composition of the aid layer may be greater than the difference between the Al composition of the quantum barrier layer and the Al composition of the aid layer.

In an embodiment, the quantum well layer may include Ga, and a difference between a Ga composition of the quantum well layer and the Ga composition of the aid layer may be smaller than a difference between a Ga composition of the quantum barrier layer and the Ga composition of the aid layer.

In an embodiment, the active layer may include a plurality of stacked quantum structures, and the quantum structure may be a structure where the quantum well layer, the aid layer, and the quantum barrier layer are sequentially stacked.

In an embodiment, the aid layers may be disposed between each adjacent quantum well layer and each quantum barrier layer.

In an embodiment, the active layer may include a plurality of stacked quantum structures, and the quantum structure may be a structure where the aid layer, the quantum well layer, the aid layer, and the quantum barrier layer are sequentially stacked.

In an embodiment, the light emitting device may further include a first layer disposed between the first window layer and the active layer to prevent holes or electrons from diffusing from the active layer to the first window layer, and a second layer disposed between the second window layer and the active layer to prevent holes or electrons from diffusing from the active layer to the second window layer.

In an embodiment, the light emitting device may further include a first clad layer disposed between the first window layer and the active layer, and a second clad layer disposed between the second window layer and the active layer.

In an embodiment, the first clad layer may be disposed between the first window layer and the first layer, and the second clad layer may be disposed between the second window layer and the second layer.

In an embodiment, one surface of the first window layer may be a light exiting surface through which light is emitted, and irregularities may be formed on the light exiting surface.

In an embodiment, the active layer may include a plurality of intersection points CPs where an Al composition profile and a Ga composition profile intersect.

In an embodiment, with respect to a virtual line L connecting the plurality of intersection points CPs, a vertical distance between the Al composition profile and the virtual line L in the quantum barrier layer may be greater than a vertical distance between the Ga composition profile and the virtual line L.

In an embodiment, with respect to the virtual line L connecting the plurality of intersection points CPs, a vertical distance between the Al composition profile and the virtual line L in the quantum well layer may be smaller than a vertical distance between the Ga composition profile and the virtual line L.

A light emitting device according to another embodiment of the disclosed technology comprises: a first window layer doped with a first conductivity type dopant, a second window layer doped with a second conductivity type dopant, an active layer disposed between the first window layer and the second window layer to generate light, a first light transmission layer disposed on one side of the first window layer, and a second light transmission layer disposed between the first light transmission layer and the first window layer, wherein the second light transmission layer may include a void. Therefore, a light path may be variously changed.

A light emitting device according to another embodiment of the disclosed technology comprises: a first window layer doped with a first conductivity type dopant, a second window layer doped with a second conductivity type dopant, and an active layer disposed between the first window layer and the second window layer to generate light, wherein the first window layer may have roughness on at least one of an upper surface and a lower surface. Therefore, scattering of light may be increased.

A light emitting device according to another embodiment of the disclosed technology comprises: a first window layer doped with a first conductivity type dopant, a second window layer doped with a second conductivity type dopant, an active layer disposed between the first window layer and the second window layer to generate light, a first layer disposed between the first window layer and the active layer, and a second layer disposed between the second window layer and the active layer, wherein the first layer and the second layer may have a symmetrical structure with respect to the active layer. Therefore, it is possible to prevent light emitted from the active layer from being focused in one direction.

A light emitting device according to another embodiment of the disclosed technology comprises: a first window layer doped with a first conductivity type dopant, a second window layer doped with a second conductivity type dopant, an active layer disposed between the first window layer and the second window layer to generate light, and an intermediate layer disposed between the active layer and the second window layer, wherein a lattice constant of the intermediate layer may have a value between the lattice constants of layers positioned over and under the intermediate layer. Therefore, a defect caused by a difference in lattice constants may be alleviated.

A light emitting device according to another embodiment of the disclosed technology comprises: a first window layer doped with a first conductivity type dopant, a second window layer doped with a second conductivity type dopant, and an active layer disposed between the first window layer and the second window layer to generate light, wherein, in an emission spectrum of the light, an integral area of a shorter wavelength region with respect to a peak wavelength may be larger than an integral area of a longer wavelength region. Therefore, visibility may be increased by increasing the spectral area in the shorter wavelength region.

### [Advantageous Effects]

The disclosed technology may provide a light emitting device that emits red light with enhanced emission efficiency and a light emitting apparatus having the same.

In addition, the disclosed technology may provide a light emitting device that is configured to improve radiation efficiency by reducing heat energy consumption in an active layer and preventing a phenomenon of carrier overflowing and a light emitting apparatus having the same.

Moreover, the disclosed technology may provide a light emitting device that is configured to improve reliability by stably connecting an electrode and a window layer through a structure in which a mesa is formed over a thick window layer and a light emitting apparatus having the same.

### [Description of Drawings]

FIG. 1 is a schematic cross-sectional view of a light emitting device according to a first embodiment of the disclosed technology.
FIG. 2 is a cross-sectional view illustrating an active layer of the light emitting device according to the first embodiment.
FIG. 3 is a diagram illustrating an energy band of the active layer of the light emitting device according to the first embodiment.
FIG. 4 is a diagram illustrating a light emitting pattern of the light emitting device according to the first embodiment.
FIG. 5 is a graph illustrating a light emitting spectrum of the light emitting device according to the first embodiment.
FIG. 6 is a graph illustrating doping profiles of gallium (Ga), aluminum (Al), indium (In), and phosphorus (P) in the light emitting device according to the first embodiment.
FIG. 7 is a schematic cross-sectional view of a light emitting device according to a second embodiment of the disclosed technology.
FIG. 8 is a cross-sectional view illustrating an active layer of the light emitting device according to the second embodiment.
FIG. 9 is a diagram illustrating an energy band of the active layer of the light emitting device according to the second embodiment.
FIG. 10 is a schematic cross-sectional view of a light emitting device according to a third embodiment of the disclosed technology.
FIG. 11 is a cross-sectional view illustrating a light emitting apparatus according to an embodiment of the disclosed technology.
FIG. 12 is a cross-sectional view illustrating a light emitting apparatus according to another embodiment of the disclosed technology.
FIG. 13 is a cross-sectional view illustrating a light emitting apparatus according to another embodiment of the disclosed technology.

### [Best Mode]

In the following description, for the purposes of explanation, numerous specific details are set forth in order to provide thorough understanding of various exemplary embodiments or implementations of the disclosed technology. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting device of the disclosed technology and a light emitting apparatus including the same will be described in detail with reference to the accompanying drawings.

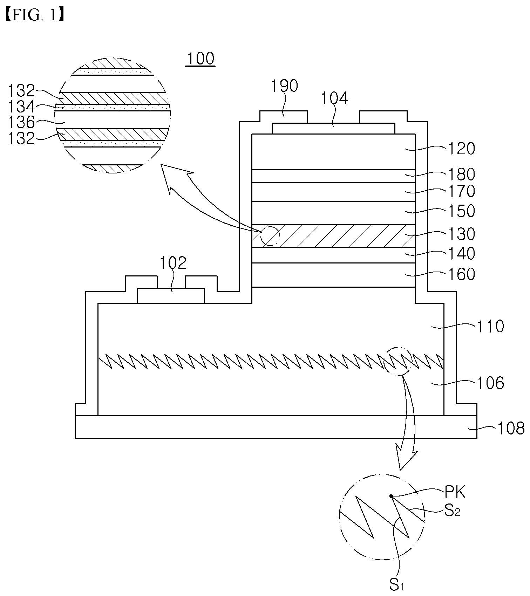

FIGs. 1 to 4 are diagrams illustrating a light emitting device 100 according to a first embodiment of the disclosed technology. First, FIG. 1 is a schematic diagram illustrating the light emitting device 100 according to the first embodiment of the disclosed technology.

Referring to FIG. 1, the light emitting device 100 according to the first embodiment may include a first window layer 110 doped with a first conductivity type dopant, a second window layer 120 doped with a second conductivity type dopant, and an active layer 130 disposed between the first window layer 110 and the second window layer 120 to generate light. The light emitting device 100 may further include a first light transmission layer 108, a second light transmission layer 106, a first layer 140, a first clad layer 160, a second layer 150, a second clad layer 170, an intermediate layer 180, a first electrode 102, a second electrode 104, and a protection layer 190.

The first light transmission layer 108 may be formed of a light-transmitting material that transmits light emitted from the active layer 130. In addition, the first light transmission layer 108 may be formed of a light-transmitting insulation material. The first light transmission layer 108 may transmit light emitted from the active layer 130, or may transmit light of a specific wavelength range. Therefore, a light emission area may be increased. For example, the first light transmission layer 108 may be formed of sapphire (Al₂O₃), silicon, gallium nitride (GaN), gallium arsenide (GaAs), epoxy, or others.

A side surface of the first light transmission layer 108 may be positioned further outward than side surfaces of semiconductor layers disposed thereover. That is, the first light transmission layer 108 may be formed to have a larger cross-sectional area than the other semiconductor layers formed over the first light transmission layer 108. Alternatively, the first light transmission layer 108 may have a larger lateral width than those of the other semiconductor layers formed over the first light transmission layer 108. Therefore, light emitted from the active layer 130 may be emitted more widely through the first light transmission layer 108 which is wider than the active layer 130.

FIG. 1 illustrates a lower surface of the first light transmission layer 108, which is a light exiting surface, as a flat structure, but the inventive concepts are not limited thereto. For example, roughness or irregularities may be formed on one surface of the first light transmission layer 108. Light that is totally reflected may be reduced by the roughness or irregularities formed on one surface of the first light transmission layer 108, thereby improving a light extraction efficiency of the light emitting device 100. The irregularities may be formed on one surface of the first light transmission layer 108 where the first light transmission layer 108 and the second light transmission layer 106 are adjacent. Therefore, a range of refraction angles of light may be increased by irregularities disposed in a region where materials with different refractive indices are adjacent. Alternatively, those may be formed on one surface of the first light transmission layer 108 that is disposed far from the second light transmission layer 106. Therefore, scattering of light emitted to the outside may be increased.

In addition, roughness or irregularities may be formed on at least one of the side surfaces of the first light transmission layer 108. The irregularities formed on the side surface may be formed in a shape having a length in a direction perpendicular to a lateral direction of the first light transmission layer 108, and the irregularities having the length may be formed in a plural number along the lateral direction of the first light transmission layer 108. As such, an irregularity structure formed in the first light transmission layer 108 may improve the light extraction efficiency of the light emitting device 100.

The second light transmission layer 106 may be disposed over the first light transmission layer 108. The second light transmission layer 106 may be formed of a transmitting material that transmits light. In addition, the second light transmission layer 106 may be formed of an insulation material. The second light transmission layer 108 may transmit all or a portion of light emitted from the active layer 130, or only light in a specific wavelength range. For example, the second light transmission layer 106 may be, without being limited to a specific material, formed of various materials as long as they can transmit light, such as silicone, polyimide, polypropylene, benzocyclobutene (BCB) silicon dioxide, or others.

In addition, the second light transmission layer 106 may be disposed between the first window layer 110 and the first light transmission layer 108 to also serve as a coupler that couples the first window layer 110 and the first light transmission layer 108.

Moreover, at least one of an upper surface and a lower surface of the second light transmission layer 106 may have roughness. When the upper surface and the lower surface of the second light transmission layer 106 have the roughness, an adhesion with the first window layer 110 or the first light transmission layer 108 may be improved by the upper surface or the lower surface, respectively. That is, the adhesion between the first window layer 110 and the first light transmission layer 108 may be improved by the second light transmission layer 106.

In addition, the roughness or radiation intensities of the upper surface and the lower surface of the second light transmission layer 106 may be same or different from each other. For example, roughness or radiation intensities of a lower surface of the first window layer 110 and an upper surface of the first light transmission layer 108 may be different from each other. Accordingly, the roughness or radiation intensity of the upper surface of the second light transmission layer 106 in close contact with the lower surface of the first window layer 110 and the roughness or radiation intensity of the lower surface of the second light transmission layer 106 in close contact with the upper surface of the first light transmission layer 108 may be different from each other. That is, the second light transmission layer 106 may play a role as a buffer that alleviates a difference in the roughness or radiation intensities between the lower surface of the first window layer 110 and the upper surface of the first light transmission layer 108, which are opposite to each other, and thus, a connection between the first window layer 110 and the first light transmission layer 108 may be easily achieved.

In addition, the second light transmission layer 106 may have a refractive index different from that of at least one of the first window layer 110 and the first light transmission layer 108. Therefore, a phenomenon in which an incident angle of light incident on an interface between the first window layer 110, the first light transmission layer 108, and the second light transmission layer 106 increases beyond a critical angle to be reflected back inside may be reduced, thereby improving light extraction efficiencies of the second light transmission layer 102 and the light emitting device 100.

The second light transmission layer 106 may include a void. Therefore, a light path may be variously changed.

The first window layer 110 is a semiconductor layer doped with a first conductivity type dopant, which may be formed by growing on a growth substrate. The growth substrate is a substrate for growing a semiconductor layer, which may have various configurations, and as an example, it may be a gallium arsenide substrate.

The first window layer 110 may be positioned over the second light transmission layer 106.

The first window layer 110 may include a phosphide or nitride semiconductor such as (Al, Ga, In)P or (Al, Ga, In)N, and may be grown using a method such as MOCVD, MBE, HVPE, or others. As an example, the first window layer 110 may be a phosphide semiconductor layer of (AlₓGa₍₁₋ₓ₎)_{y}In_{(1-y)}P (0≤x≤1, 0≤y≤1) doped with a first conductivity type.

The first window layer 110 may be doped with a first conductivity type dopant. As an example, the first conductivity type dopant may be an n-type dopant. The n-type dopant may include at least one type of impurity such as silicon (Si), tellurium (Te), boron (B), phosphorus (P), arsenide (As), antimony (Sb), germanium (Ge), selenium (Se), or others. The first window layer 110 may include a single type of dopant or may include a plurality of types of dopants. As an example, the first window layer 110 may be doped with Si, doped with Te, or doped with a mixture of Si and Te. When the first window layer 110 is doped with the n-type dopant, electrons may be supplied to the active layer 130. However, the inventive concepts are not limited thereto, and the first window layer 110 may be doped with an opposite conductivity type, including a p-type dopant. The p-type dopant may include at least one type of impurity such as Mg, C (carbon), or the like.

The first window layer 110 may transmit light generated in the active layer 130, and may be formed of a material with low resistivity. In addition, the first window layer 110 may be formed of a material having an energy band gap larger than that of the active layer 130. For example, the first window layer 110 may be formed of InₓGa_{y}Al_{z}P (0≤x≤1, 0≤y≤1, 0≤z≤1) doped with a first conductivity type dopant. Herein, a relationship between x, y, and z may be x*0.8≤y+z≤x*1.2 or x+y+z=1. In addition, z may be 0.15≤z≤0.4. The first window layer 110 having such a composition of aluminum (Al) may reduce an absorption of light emitted from the active layer 130, thereby improving the light extraction efficiency.

In addition, the first window layer 110 may have a refractive index greater than that of another adjacent layer disposed over or under the first window layer 110. When the first window layer 110 has the refractive index greater than that of another adjacent layer thereover or thereunder, the light extraction efficiency of the light emitting device 100 may be improved. For example, the refractive index of the first window layer 110 may be about 3.05 to about 3.2.

In addition, the first window layer 110 may include a layer doped at a high level with a first conductivity type dopant. For example, a doping concentration of at least a partial region of the first window layer 110 may be 5E17 atoms/cm³ or more and 5E18 atoms/cm³ or less. However, the embodiments of the disclosed technology are not limited thereto.

The first window layer 110 may include a layer doped at a high level and a layer doped at a relatively low level.

In addition, roughness or irregularities may be formed on at least one of an upper surface and a lower surface (a surface facing the second light transmission layer 106) of the first window layer (110). When the irregularities are formed on the lower surface of the first window layer 110 doped at the high level, the irregularities are easily formed, and an adhesion may be improved when bonding at an interface with the second light transmission layer 106. In addition, by the lower surface of the first window layer (110) having a roughness or irregularity structure, scattering of light may be increased and the light extraction efficiency of the first window layer (110) may be improved.

In addition, when the first window layer 110 is formed of InₓGa_{y}Al_{z}P(0≤x≤1, 0≤y≤1, 0≤z≤1) doped with the first conductivity type dopant, irregularities of regular or irregular shapes may be formed during an etching process. A total reflection of light on the lower surface of the first window layer 110 may be reduced by the irregularities, and an amount of light emitted to the outside of the first window layer 110 may be increased. Therefore, the light emitting device 100 may improve the light extraction efficiency and a radiation efficiency by forming the irregularities on one surface of the first window layer 110 and allowing light to be emitted through the one surface of the first window layer 110 where the irregularities are formed.

For example, referring to FIG. 1, the irregularities may include a peak point PK and a first side S1 and a second side S2 extending in both directions from the peak point PK, and lengths of the first side S1 and the second side S2 may be different from each other. In addition, an angle formed by the first side S1 and the second side S2 may be an acute angle. In addition, gradients (slopes) of the first side S1 and the second side S2 may be different from each other. For example, with respect to an interface between the first window layer 111 and the first clad layer 121 described later, the slope of the first side S1 and that of the second side S2 may be different from each other. In addition, the peak point PK may be formed in a direction toward either the first side S1 or the second side S2.

In addition, irregularities may also be formed on an upper surface of the first window layer 110. The upper surface having the irregularity structure of the first window layer 110 may also improve the light extraction efficiency in the first window layer 110.

The second window layer 120 may be a semiconductor layer disposed over the first window layer 110.

The second window layer 120 may include a phosphide or nitride semiconductor such as (Al, Ga, In)P or (Al, Ga, In)N, and may be grown using a technique such as MOCVD, MBE, HVPE, or others. As an example, the second window layer may be a phosphide semiconductor layer of InₓGa_{y}Al_{z}P(0≤x≤1, 0≤y≤1, 0≤z≤1) or GaP doped with a second conductivity type.

The second window layer 120 may be doped with a second conductivity type dopant having a conductivity type opposite to that of the first window layer 120. As an example, the second conductivity type dopant may be a p-type dopant. The p-type dopant may include at least one type of impurity such as Mg, C (carbon), or others. For example, the second window layer 120 may be doped as the p-type including the impurity such as Mg or C (carbon). The second window layer 120 may be configured to include one group III element.

The second window layer 120 may be formed of a material having an energy band gap larger than that of the active layer 130. For example, the second window layer 120 may be formed of GaP doped with a p-type dopant. Herein, the p-type dopant may be at least one of magnesium (Mg) or carbon (C).

The second window layer 120 may supply holes to the active layer 130.

According to an embodiment of the disclosed technology, a portion of the second window layer 120 may be etched to expose a portion of the upper surface of the first window layer 110. A portion of the first window layer 110 may also be etched together. In this way, an upper portion of the first window layer 110 that is etched to have a cross-sectional area smaller than that of the lower surface of the first window layer 110 may form a mesa structure together with the second window layer 120.

The active layer 130 is a light emitting layer positioned between the first window layer 110 and the second window layer 120 and can have various configurations. The active layer 130 is a layer where electrons injected from the first window layer 110 and holes injected from the second window layer 120 recombine, and light may be generated through the recombination of electrons and holes.

The active layer 130 may include a phosphide or nitride semiconductor such as (Al, Ga, In)P or (Al, Ga, In)N, and may be grown using a technique such as MOCVD, MBE, HVPE, or others. As an example, the active layer 130 may have any one of compositions of InₓGa_{y}Al_{z}P(0≤x≤1, 0≤y≤1, 0≤z≤1) and InₓGa_{y}P(0≤x≤1, 0≤y≤1).

Light generated in the active layer 130 may travel in a direction of the first window layer 110 or the second window layer 120, and may be emitted to the outside of the light emitting device 100 through the lower surface of the first light transmission layer 108 or the second window layer 120. However, the inventive concepts are not limited to light generated in the active layer 100 being emitted through the lower surface of the first light transmission layer 108, and may also be emitted to other directions.

The light emitting device 100 may be formed to have an exiting surface from which light is emitted, and light generated in the active layer 130 may be emitted to the outside of the light emitting device 100 through a region defined as the exiting surface.

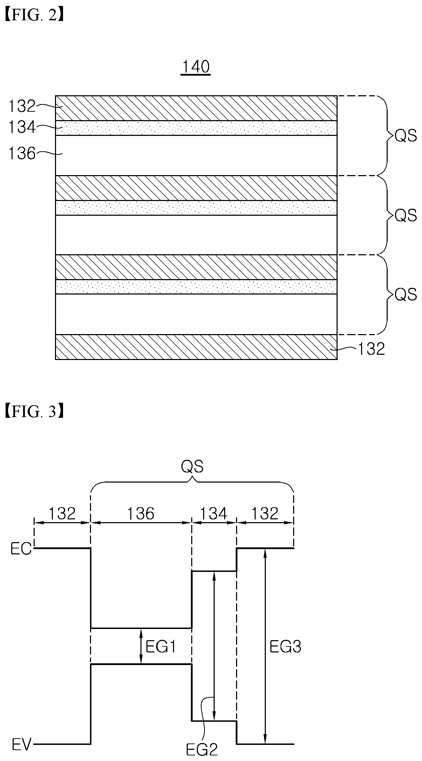

The active layer 130 may be formed in any one of a single well structure, a multi-well structure, a single quantum well structure, a multi quantum well (MQW) structure, a quantum dot structure, or a quantum wire structure. Referring to FIGs. 1 and 2, in this embodiment, the active layer 130 may be formed as a multi quantum well (MQW) structure in which a quantum well layer 136 and a quantum barrier layer 132 are repeated. For example, light emitted from the active layer 130 may have a peak wavelength in a wavelength range of about 600 nm to about 700 nm.

In an embodiment, the light emitting device 100 may further include the first clad layer 160 and the second clad layer 170. The first clad layer 160 may be disposed between the first window layer 110 and the active layer 130. The second clad layer 170 may be disposed between the second window layer 120 and the active layer 130.

First, the first clad layer 160 may be disposed over the first window layer 110. The first clad layer 160 may reduce a speed of electrons from the first window layer 110 toward the active layer 130, thereby playing a role of preventing an excessive amount of electrons from being injected into the active layer 130 at a high speed. To this end, the first clad layer 160 may be set to have an aluminum (Al) composition higher than that of the first window layer 110, thereby having an energy band gap higher than that of the first window layer 110.

For example, the first clad layer 160 may be formed of InₓAl₍₁₋ₓ₎P doped with an n-type dopant. Herein, x may be 0.4≤x≤0.6. A thickness of the first clad layer 160 may be about 200 nm or more, and preferably, may be about 200 nm to about 600 nm. In addition, a doping concentration of the first clad layer 160 may be about 1E17 to about 1E18 atoms/cm³.

Electrons move faster than holes. However, by reducing the speed of electrons moving from the first window layer 110 to the active layer 130 by the first clad layer 160, numbers of electrons and holes in the active layer 130 may be balanced, thereby improving the radiation efficiency of the active layer 130.

Next, the second clad layer 170 may be disposed between the second window layer 120 and the active layer 130.

The second clad layer 170 may be disposed over the first window layer 110. The second clad layer 170 may prevent electrons from overflowing across the active layer 130 to the direction of the second window layer 120. The second clad layer 170 may have an aluminum (Al) composition larger than that of the second window layer 120 to have an energy band gap higher than that of the second window layer 120. For example, the second clad layer 170 may be formed of InₓAl₍₁₋ₓ₎P doped with a p-type dopant. Herein, x may be 0.4≤x≤0.6. A thickness of the second clad layer 170 may be about 600 nm or less, and preferably, may be about 300 nm to about 600 nm. In addition, a doping concentration of the second clad layer 170 may be about 1E17 to about 1E18 atoms/cm³.

In an embodiment, the light emitting device 100 may further include the first layer 140 disposed over the first window layer 110. The first layer 140 is a layer disposed between the first window layer 110 and the active layer 130 to prevent holes (or electrons) from diffusing from the active layer 130 to the first window layer, and can have various configurations.

The first layer 140 may be disposed between the first clad layer 160 and the active layer 130. The first clad layer 160 may be disposed between the first window layer 110 and the first layer 140. That is, the first layer 140 may be positioned over the first clad layer 160.

The first layer 140 may play a role as a barrier to prevent holes from passing from the active layer 130 to the first clad layer 160 or the first window layer 110.

The first layer 140 may prevent holes from recombining with electrons in a region other than the active layer 130. That is, by preventing electrons from recombining with holes in the region other than the active layer 130 by the first layer 140, a sufficient number of electrons may be allowed to move to the active layer 130. Therefore, the first layer 140 may improve the radiation efficiency in the active layer 130 by allowing the sufficient number of electrons to recombine with holes in the active layer 130.

For example, the first layer 140 may be formed of InGaAlP that is not doped with a dopant. Furthermore, the first layer 140 may include InₓGa_{y}Al_{z}P. Herein, x, y, and z may satisfy x*0.8≤y+z≤x*1.2 or x+y+z=1. In addition, z may satisfy 0.15≤z≤0.4. Moreover, the first layer 140 may have a doping concentration lower than that of the first clad layer 160 or the first window layer 110.

In an embodiment, the light emitting device 100 may further include the second layer 150 disposed over the first window layer 110. The second layer 150 is a layer disposed between the second window layer 120 and the active layer 130 to prevent electrons (or holes) from diffusing from the active layer 130 to the second window layer 120, and can have various configurations.

The second layer 150 may be disposed between the second clad layer 170 and the active layer 130. The second clad layer 170 may be disposed between the second window layer 210 and the second layer 150. That is, the second layer 150 may be positioned over the active layer 130, and the second clad layer 170 may be positioned over the second layer 150.

The second layer 150 may play a role as a barrier to prevent electrons from passing from the active layer 130 to the second clad layer 170 and the second window layer 120. The second layer 150 may play a role as a barrier to prevent electrons from crossing the active layer 130 and recombining with holes in the second clad layer 170 or the second window layer 120. Therefore, by preventing holes from recombining with electrons before reaching the active layer 130 by the second layer 150, a sufficient number of holes may be allowed to move to the active layer 130. Therefore, the second layer 150 may improve the radiation efficiency in the active layer 130 by allowing the sufficient number of holes to recombine with electrons in the active layer 130. For example, the second layer 150 may be formed of InₓGa_{y}Al_{z}P that is not doped with a dopant. Herein, x, y, and z may satisfy x*0.8≤y+z≤x*1.2 or x+y+z=1. In addition, z may satisfy 0.15≤z≤0.4. In addition, the second layer 150 may have a doping concentration lower than that of the second clad layer 170 or the second window layer 120. Therefore, the speed of movement of holes may be adjusted.

The active layer 130 may be positioned between the first layer 140 and the second layer 150. That is, the first layer 140 and the second layer 150 are disposed over and under, with respect to the active layer 130, and the first layer 140 and the second layer 150 may have a symmetrical structure with respect to the active layer 130. Therefore, it is possible to prevent light emitted from the active layer 130 from being focused in one direction.

In an embodiment, the light emitting device 100 may further include the intermediate layer 180 disposed over the first window layer 110. The intermediate layer 180 may be disposed between the second clad layer 170 and the second window layer 120. That is, the intermediate layer 180 may be disposed over the second clad layer 170, and the second window layer 120 may be disposed over the intermediate layer 180.

The intermediate layer 180 may alleviate a defect caused by a difference in lattice constants between a layer positioned over the intermediate layer 180 and a layer positioned under the intermediate layer 180. Therefore, a lattice constant of the intermediate layer 180 may have a value between a lattice constant of the layer positioned over the intermediate layer 180 and a lattice constant of the layer positioned under the intermediate layer 180.

In this embodiment, the intermediate layer 180 may alleviate lattice defects of the second clad layer 170 and the second window layer 120. Therefore, the lattice constant of the intermediate layer 180 may have a value between a lattice constant of the second clad layer 170 and a lattice constant of the second window layer 120.

By alleviating the lattice defects between the second clad layer 170 and the second window layer 120 through the intermediate layer 180, current loss, interface stress, or others due to the lattice defects may be reduced, thereby improving a reliability of the light emitting device 100.

According to the embodiment of the disclosed technology, the first electrode 102 may be positioned on the upper surface of the first window layer 110 exposed from a mesa structure. The first electrode 102 may be in contact with the first window layer 110 to be electrically connected to each other. The first electrode 102 may include a conductive material, and may be formed of any type of metal capable of being in ohmic contact with the first window layer 110.

According to this embodiment, a mesa structure may be positioned in an upper portion of the first window layer 110. When an etching process for forming the mesa structure is performed, a portion of the upper portion of the first window layer 110 may also be etched together. In this case, since a thickness of the first window layer 110 is large, a stable thickness may be maintained even during the etching process, and accordingly, a stable connection with the first electrode 102 may be made, and further, the reliability of the light emitting device 100 may be improved.

In addition, the second electrode 104 may be positioned on the upper surface of the second window layer 120. The second electrode 104 may be in contact with the second window layer 120 to be electrically connected to each other. The second electrode 104 may include a conductive material, and may be formed of any type of metal capable of being in ohmic contact with the second window layer 120.

The protection layer 190 may cover a surface of a light emitting structure to protect the light emitting device 100. Herein, the light emitting structure is semiconductor layers forming the light emitting device 100.

The protection layer 190 may be formed of an insulation material. In addition, the protection layer 190 may include a first opening exposing at least a portion of the first electrode 102 and a second opening exposing at least a portion of the second electrode 104.

The first electrode 102 and the second electrode 104 exposed by the first opening and the second opening of the protection layer 190 may be electrically connected to an external configuration of the light emitting device 100. In addition, the protection layer 190 may be formed of a light transmitting material. The light emitting device 100 may emit light through regions where no light-reflective material is positioned. For example, the protection layer 190 may be an oxide such as SiO₂, TiO₂, AlOₓ, NiOₓ, or others.

Alternatively, the protection layer 190 may be formed of a non-transparent material that does not transmit light or a light-reflective material, or may be a light reflection layer formed of a light transmitting material. When the protection layer 190 is formed of the non-transparent material that does not transmit light or the light-reflective material, the light emitting device 100 of this embodiment may emit light to the outside through an exposed lower surface that is not covered by the protection layer 190. The protection layer 190 may include a plurality of materials having different refractive indices from one another, and may have a structure in which a plurality of different materials are alternately stacked. The protection layer 190 may include a DBR.

In an embodiment, the protection layer 190 may include a first opening exposing at least a portion of the first window layer 110 and a second opening exposing at least a portion of the second window layer 120. The first electrode 102 may be dispose over the first opening, and the second electrode 104 may be disposed over the second opening. Therefore, the first window layer 110 and the second window layer 120 exposed to the outside through the first opening and the second opening of the protection layer 190 may be electrically connected to the external configuration of the light emitting device 100.

The light emitting device 100 of this embodiment includes the first electrode 102 and the second electrode 104, but these may be omitted. In this case, the first opening of the protection layer 190 may expose a partial region of the first window layer 110 exposed from the mesa structure. In addition, the second opening of the protection layer 190 may expose a partial region of the second window layer 120.

FIG. 2 is a schematic diagram illustrating the active layer 130 of the light emitting device 100 according to the first embodiment of the disclosed technology.

The active layer 130 of the light emitting device 100 according to the first embodiment may include at least one quantum barrier layer 132, at least one quantum well layer 136, and at least one aid layer 134.

The aid layer 134 may be disposed between the quantum barrier layer 132 and the quantum well layer 136.

Referring to FIG. 2, the active layer 130 may include the quantum well layer 136, the aid layer 134 positioned over the quantum well layer 136, and the quantum barrier layer 132 positioned over the aid layer 134. Herein, the quantum well layer 136, the aid layer 134 stacked over the quantum well layer 136 and the quantum barrier layer 132 stacked over the aid layer 134 may be a pair of quantum structures QSs. That is, the quantum structure QS may be a structure where the quantum well layer 136, the aid layer 134, and the quantum barrier layer 132 are sequentially stacked.

In an embodiment, as illustrated in FIG. 2, a first quantum barrier layer 132 may be positioned on the first layer 140, and active layer 130 may have a structure in which at least one pair of quantum structures QSs are stacked over the first quantum barrier layer 132. The quantum structure QS may be disposed over the quantum barrier layer 132 to prevent light emitted from the quantum structure QS from being absorbed at an interface of the quantum structure QS.

The quantum well layer 136 may be formed of InₓGa_{y}P(0≤x≤1, 0≤y≤1, x+y=1), and a thickness thereof may be about 3 nm to about 7 nm.

The quantum barrier layer 132 and aid layer 134 may include aluminum (Al) and gallium (Ga). As an example, the quantum barrier layer 132 and the aid layer 134 may be formed of Inₓ(Ga_{y}Al_{z})P. In a relationship between y and z, y+z may have a value corresponding to x*0.8≤y+z≤x*1.2. Alternatively, it may be x+y+z=1. In addition, z may have a composition of 0.15≤z≤0.4. Therefore, it may facilitate that an appropriate amount of electrons enter the quantum well layer 136 and electrons that cannot enter the quantum well layer 136 move across the quantum barrier layer 132.

In addition, a difference in gallium compositions between the quantum well layer 136 and the aid layer 134 may be greater than a difference in gallium compositions between the aid layer 134 and the quantum barrier layer 132. In addition, a difference in aluminum compositions between the quantum well layer 136 and the aid layer 134 may be greater than a difference in aluminum compositions between the aid layer 134 and the quantum barrier layer 132. A difference in composition of a material that has four or fewer electron shells, that is, electrons, may be made greater between the aid layer 134 and the quantum well layer 136 than between the aid layer 134 and the quantum barrier layer 132. Therefore, a compositional difference of a material with a low energy level may be made larger in a region close to the quantum well layer 136, thereby increasing a probability of electrons and holes combining.

FIG. 3 is a diagram illustrating an energy band of the active layer 130 of the light emitting device 100 according to the first embodiment of the disclosed technology. In more detail, FIG. 3 illustrates energy bands of the first quantum barrier layer 132 of the active layer 130 positioned on the first layer 140 in the first embodiment and the pair of quantum structures QSs positioned thereover.

Referring to FIG. 3, the quantum well layer 136, the quantum barrier layer 132 and the aid layer 134 may have different energy band gaps from one another. In FIG. 3, EC represents a conduction band, EV represents a valence band, and a difference between EC and EV may correspond to a band gap energy.

According to the embodiment of the disclosed technology, the aid layer 134 positioned between the quantum well layer 136 and the quantum barrier layer 132 has an energy band gap between those of the quantum well layer 136 and the quantum barrier layer 132. An energy band gap EG2 of the aid layer 134 may be smaller than an energy band gap EG1 of the quantum barrier layer 132 and larger than an energy band gap EG3 of the quantum well layer 136.

Heights of the quantum barrier layer 132 and the aid layer 134, that is, sizes of the energy band gaps EG1 and EG2, may be adjusted by a composition of aluminum or indium. For example, an aluminum composition of the quantum barrier layer 132 may be greater than gap that of the aid layer 134. That is, the Al composition of the aid layer 134 may be smaller than that of the quantum barrier layer 132.

Furthermore, among compositions of aluminum (Al) and gallium (Ga), the quantum barrier layer 132 may contain more than 50% aluminum, and the aid layer 134 may contain less than 50% aluminum. In addition, a difference between the aluminum compositions of the quantum barrier layer 132 and the aluminum composition of the aid layer 134 may be 10% or more.

Referring to FIG. 3, in the active layer 130 of this embodiment, the quantum well layer 136 configuring one quantum structure QS is connected to the aid layer 134 having a relatively lower energy band gap compared to that of the quantum barrier layer 132. Herein, the aid layer 134 may be formed between the quantum well layer 136 and the quantum barrier layer 132 positioned in a direction toward the second window layer 120. Therefore, a potential barrier between the quantum well layer 36 and the aid layer 134 is lower than a potential barrier between the quantum well layer 136 and the quantum barrier layer 132. An energy required for an electron to fall into the valence band may be reduced by the lowered potential barrier. That is, an energy consumed by a heat dissipation of electrons may be reduced by the aid layer 134, thereby improving the radiation efficiency of the active layer 130.

In addition, according to this embodiment, the quantum barrier layer 132 having a larger energy band gap than that of the aid layer 134 may be formed on one side of the aid layer 134 in the direction toward the second window layer 120. Since the potential barrier of the aid layer 134 is low, a carrier overflow phenomenon may occur, but since the quantum barrier layer 132 has the potential barrier greater than that of the aid layer 134, carriers that have overflowed into the aid layer 134 may be prevented from diffusing to other regions any further.

As such, the active layer 130 of the light emitting device 100 according to the embodiment of the disclosed technology forms the aid layer 134 having the energy band gap smaller than that of the quantum barrier layer 132 between the quantum well layer 136 and the quantum barrier layer 132, which may reduce carriers to overflow while reducing a release of electron energy as heat, thereby improving the radiation efficiency of the light emitting device 100.

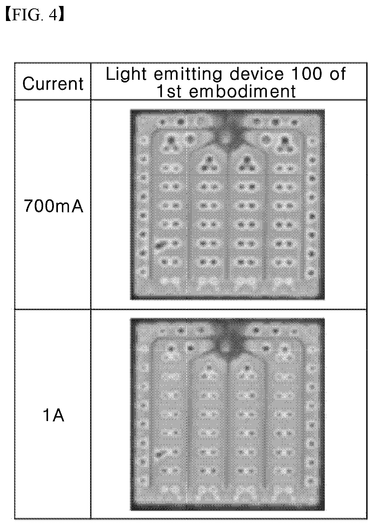

FIG. 4 is a diagram illustrating a light emitting pattern of the light emitting device 100 according to the first embodiment of the disclosed technology. In FIG. 4, colors represent radiation intensities, and are displayed in an order of blue, green, yellow, and red from a region with a low radiation intensity to a region with a high radiation intensity. That is, the radiation intensity is blue < green < yellow < red.

Referring to FIG. 4, it can be seen that a radiation intensity in a region where holes are injected is large and uniform.

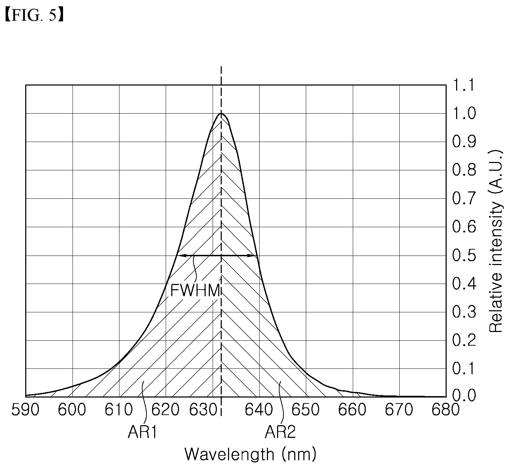

FIG. 5 is a diagram illustrating a light emitting spectrum of the light emitting device 100 according to the first embodiment of the disclosed technology.

Referring to FIG. 5, the light emitting device 100 according to the first embodiment may have a full width at half maximum (FWHM) of about 15 nm to about 25 nm. In addition, an integral area AR1 of a spectrum corresponding to a shorter wavelength region with respect to a peak wavelength (nm) of the emission spectrum may be larger than an integral area AR2 of a spectrum corresponding to a longer wavelength region. Therefore, a visibility of red may be increased by increasing a spectral area in a region close to a green wavelength band with high visibility.

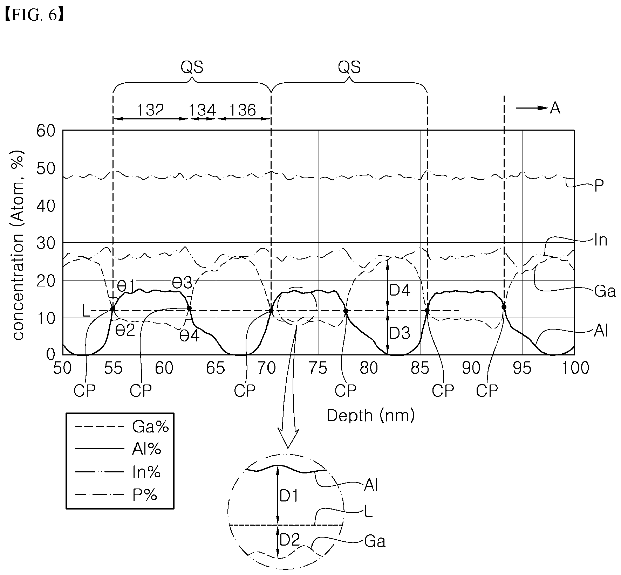

FIG. 6 is a graph illustrating composition profiles of gallium (Ga), aluminum (Al), indium (In), and phosphorus (P) of the active layer 130 of the first embodiment of the disclosed technology.

In the active layer 130, phosphorus (P) may have a composition profile between about 44% and about 50%, which slightly changes with depth. In addition, referring to FIG. 6, the phosphorus (P) composition profile in the active layer 130 may have a shape that changes between about 44% and about 50%.

In an embodiment, the active layer 130 may include a plurality of intersection points CPs where the aluminum composition profile and the gallium composition profile intersect. The aluminum composition profile and the gallium composition profile may be positioned in opposite directions with respect to a virtual line L connecting the plurality of intersection points CPs. That is, the aluminum composition profile and the gallium composition profile may oscillate. With respect to the plurality of intersection points CPs of the virtual line L, the aluminum composition profile may have a sine profile and the gallium composition profile may have a cosine profile, and the sine profile and the cosine profile may intersect at the intersection points CPs. Therefore, it is possible to form a stable flow of change in a composition of a material, thereby reducing defects occurring in the active layer 130.

For example, in the quantum barrier layer 132, an aluminum composition profile is positioned over the virtual line L, and a gallium composition profile is positioned under the virtual line L. In addition, in the aid layer 134 and the quantum well layer 136, an aluminum composition profile is positioned under the virtual line L, and a gallium composition profile is positioned over the virtual line L.

With respect to the virtual line L, the gallium composition profiles of the aid layer 134 and the quantum barrier layer 132 are positioned in opposite directions, and the aluminum composition profiles of the aid layer 134 and the quantum barrier layer 132 may also be positioned opposite to each other.

According to an embodiment, the quantum barrier layer 132, the aid layer 134, and the quantum well layer 136 may be sequentially disposed with respect to the plurality of intersection points CPs.

In addition, with respect to the virtual line L connecting the plurality of intersection points CPs, a vertical distance D1 between the Al composition profile and the virtual line L in the quantum barrier layer 132 may be greater than a vertical distance D2 between the Ga composition profile and the virtual line L. That is, the quantum barrier layer 132 may have the vertical distance D1 from a center depth to the aluminum composition profile greater than the vertical distance D2 to the gallium composition profile with respect to the virtual line L. In the quantum barrier layer 132, a composition of an atom disposed between a largest atom and a smallest atom among aluminum, indium, and gallium may be disposed close to the virtual line L. Therefore, an occurrence of a defect may be reduced by adjusting a balance of atomic sizes configuring the quantum barrier layer 132.

In addition, with respect to the virtual line L connecting the plurality of intersection points CPs, a vertical distance D3 between the Al composition profile in the quantum well layer 136 and the virtual line L may be smaller than a vertical distance D4 between the Ga composition profile and the virtual line L. That is, the quantum well layer 136 may have the vertical distance D3 from a center depth of the quantum well layer 136 to the aluminum composition profile smaller than the vertical distance D4 to the gallium composition profile with respect to the virtual line L. In the quantum well layer 136, a composition of an atom with the smallest atomic size among aluminum, indium, and gallium may be disposed close to the virtual line L. Therefore, a quality of the quantum well layer 136 may be increased by adjusting the balance of the atomic sizes configuring the quantum well layer 136.

A composition difference between gallium and aluminum at the central depth position of the quantum barrier layer 132 may be smaller than a composition difference between gallium and aluminum at the central depth position of the quantum well layer 136.

Each of the gallium composition profile and the aluminum composition profile may have different gradients on both sides relative to a vertical line passing through the intersection point CP. Herein, the gradient, with respect to the virtual line L, is a slope of a straight line connecting points spaced by an arbitrary depth from the intersection point CP. Herein, the arbitrary depth may be a depth 1 nm apart in the upward and downward depth direction from the intersection point CP.

Furthermore, each of the gallium composition profile and the aluminum composition profile may have a gradient of a composition profile adjacent to the intersection point CP in the aid layer 134 that is gentler than a gradient of the composition profile adjacent to the intersection point CP in the quantum barrier layer 132.

Referring to FIG. 6, the aid layer 134 may have variable compositions of aluminum and gallium from an adjacent quantum well layer 136 to an adjacent quantum barrier layer 132. A difference between the aluminum composition and the gallium composition in the aid layer 134 may increase toward the adjacent quantum well layer 136. That is, the difference in the compositions (contents) of gallium and aluminum in the aid layer 134 may increase as it gets farther away from the adjacent quantum barrier layer 132 and also as it gets closer to the adjacent quantum well layer 136.

In this case, the gradient of the aluminum composition profile in the aid layer 134 may be different from that of the gallium composition profile. For example, the gradient of the gallium composition profile of the aid layer 134 may be greater than that of the aluminum composition profile. That is, a rate of change in the gallium composition profile in the aid layer 134 may be greater than a rate of change in the aluminum composition profile. Herein, the rate of change may be a rate of increase or decrease in composition at a depth within a certain range.

In addition, each of slopes of the gallium composition profile and the aluminum composition profile of the aid layer 134 may be different from slopes of the gallium composition profile and the aluminum composition profile of the adjacent quantum well layer 136. Herein, slopes at points spaced apart by a same arbitrary depth with respect to the intersection point CP may be compared. Herein, the arbitrary depth may be a depth 1 nm apart in the upward and downward depth direction from the intersection point CP. For example, the slope of the gallium composition profile of the aid layer 134 may be greater than the slope of the gallium composition profile of the adjacent quantum well layer 136. In addition, the aluminum composition profile of the aid layer 134 may have a region having a greater slope than that of the aluminum composition profile of the adjacent quantum well layer 136.

In addition, a difference between the aluminum composition of the quantum well layer 136 and the aluminum composition of the aid layer 134 may be greater than a difference between the aluminum composition of the quantum barrier layer 132 and the aluminum composition of the aid layer 134.

A difference between the gallium composition of the quantum well layer 136 and the gallium composition of the aid layer 134 may be smaller than a difference between the gallium composition of the quantum barrier layer 132 and the gallium composition of the aid layer 134.

Meanwhile, in FIG. 6, the intersection points CPs are points where the aluminum composition profile and the gallium composition profile intersect, and first to fourth angles Θ1 to Θ4 may be formed through the aluminum composition profile and the gallium composition profile intersecting at the intersection points CPs. For one intersection point CP adjacent to the quantum well layer 136, with the virtual line L as a boundary, the first angle Θ1 may be formed thereover, and the second angle Θ2 may be formed thereunder. For another intersection point CP adjacent to the aid layer 136, with the virtual line L as the boundary, the third angle Θ3 may be formed thereover, and the fourth angle Θ4 may be formed thereunder. As the quantum structures QSs are sequentially stacked, the first to fourth angles Θ1 to Θ4 may be repeated in a direction toward the first window layer 110 (direction A in FIG. 6). In this case, the first angle Θ1 and the second angle Θ2 may be different from each other. The third angle Θ3 and the fourth angle Θ4 may be different from each other.

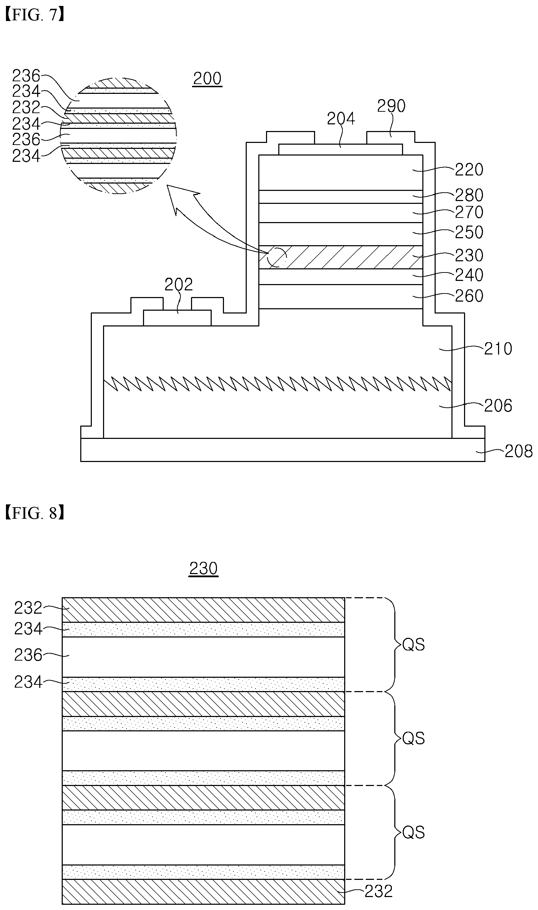

FIGs. 7 to 9 are diagrams illustrating a light emitting device 200 according to a second embodiment of the disclosed technology.

FIG. 7 is a schematic diagram illustrating the light emitting device 200 according to the second embodiment of the disclosed technology. In addition, FIG. 8 is a schematic diagram illustrating an active layer 240 of the light emitting device 200 according to the second embodiment of the disclosed technology.

The light emitting device 200 according to the second embodiment of the disclosed technology may be configured to be identical or similar to the light emitting device (100 of FIG. 1) according to the first embodiment except for the active layer 130.

Referring to FIG. 8, the active layer 230 of the light emitting device 200 according to the second embodiment may include at least two quantum barrier layers 232, at least one quantum well layer 236 and at least two aid layers 234.

The active layer 230 in the second embodiment differs from the active layer 130 of the light emitting device (100 in FIG. 1) in that the aid layers 234 are formed on both sides of the quantum well layer 236.

Referring to FIG. 8, the aid layers 236 are formed between each quantum barrier layer 232 and each quantum well layer 236. In this embodiment, the active layer 230 may include a pair of quantum structures QSs in which the aid layer 234, the quantum well layer 236, the aid layer 234, and the quantum barrier layer 232 are sequentially stacked. That is, the quantum structure QS may be formed by sequentially stacking the aid layer 234, the quantum well layer 236, the aid layer 234, and the quantum barrier layer 232. Therefore, in the light emitting device 200 according to the second embodiment, the aid layers 234 may be disposed between adjacent each quantum barrier layer 232 and each quantum well layer 236.

In addition, in this embodiment, the active layer 230 may have a structure in which a first quantum barrier layer 232 positioned on a first layer 240 and at least one pair of quantum structures QSs described above are stacked on the quantum barrier layer 232.

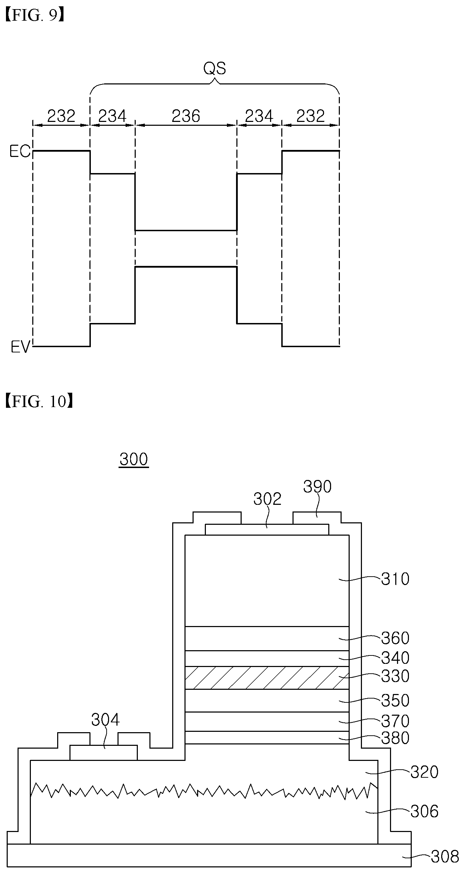

FIG. 9 is a diagram illustrating an energy band of the active layer 230 of the light emitting device 200 according to the second embodiment. In more detail, FIG. 9 shows energy bands of the first quantum barrier layer 232 of the active layer 230 positioned on the first layer 240 in the second embodiment and a pair of quantum structures QSs positioned thereover.

The quantum well layer 236, the quantum barrier layer 232, and the aid layer 234 have different energy band gaps EG1, EG2, and EG3 from one another. Therefore, as illustrated in FIG. 9, the energy band gap of the active layer 230 of the second embodiment decreases as it goes from the quantum barrier layer 232 in a direction of a first window layer 210 to the aid layer 234 and the quantum well layer 236. In addition, the energy band gap of the active layer 230 increases as it goes from the quantum well layer 236 toward the aid layer 234 in a direction of a second window layer 220 and the quantum barrier layer 232.

Such a structure of the active layer 230 of this embodiment may improve a radiation efficiency of the active layer 230 by reducing an energy consumed by carriers moving to a valence band and released as heat. In addition, the structure of the active layer 230 of this embodiment may prevent an occurrence of a carrier overflow phenomenon, thereby improving the radiation efficiency of the active layer 230.

FIG. 10 is a schematic diagram illustrating a light emitting device 300 according to a third embodiment of the disclosed technology.

The light emitting device 300 according to the third embodiment emits light in a direction different from that of the light emitting device (100 of FIG. 1) according to the first embodiment.

Referring to FIG. 10, the light emitting device 300 according to the third embodiment may have a structure in which a first light transmission layer 308, a second light transmission layer 306, a second window layer 320, an intermediate layer 380, a second clad layer 370, a second layer 350, an active layer 330, a first layer 340, a first clad layer 360, and a first window layer 310 are sequentially stacked. That is, in the light emitting device 300 of the third embodiment, an order of stacking semiconductor layers on the first light transmission layer 308 and the second light transmission layer 306 is opposite to that of the light emitting device (100 of FIG. 1) of the first embodiment. Therefore, in the light emitting device (100 of FIG. 1) of the first embodiment, light emitted from the active layer 130 may pass through the first window layer 110 to be emitted to the outside, but in the light emitting device 300 of the third embodiment, light emitted from the active layer 230 may pass through the second window layer 320 to be emitted to the outside.

A lower surface of the second window layer 320 through which light passes may have irregularities formed thereon. Since the second window layer 320 is formed of GaP doped with a p-type dopant, irregularities with irregular shapes may be formed when etching is performed. An irregularity structure formed on one surface of the second window layer 320 may reduce a total reflection of light, thereby improving light extraction efficiency compared to when light passes through a flat surface. In this embodiment, the irregularities are formed on the lower surface of the second window layer 320, but the inventive concepts are not limited thereto. An upper surface and the lower surface of the second window layer 320 may be flat surfaces without the irregularities formed thereon. In addition, the second window layer 320 may have the irregularities formed only on the upper or lower surface, or may have the irregularities formed on both the upper and lower surfaces.

In this embodiment, a portion of an upper portion of the second window layer 320 and portions of the second clad layer 370 to the first window layer 310 positioned in the upper portion of the second window layer 320 may be partially etched to form a mesa structure.

A first electrode 302 may be formed on an upper surface of the first window layer 310. In addition, a second electrode 304 may be positioned on the upper surface of the second window layer 320 exposed from the mesa structure.

In addition, the active layer 330 of this embodiment may be configured to be identical or similar to the active layer 130 of the light emitting device (100 of FIG. 1) of the first embodiment or the active layer 230 of the light emitting device (200 of FIG. 6) of the second embodiment.

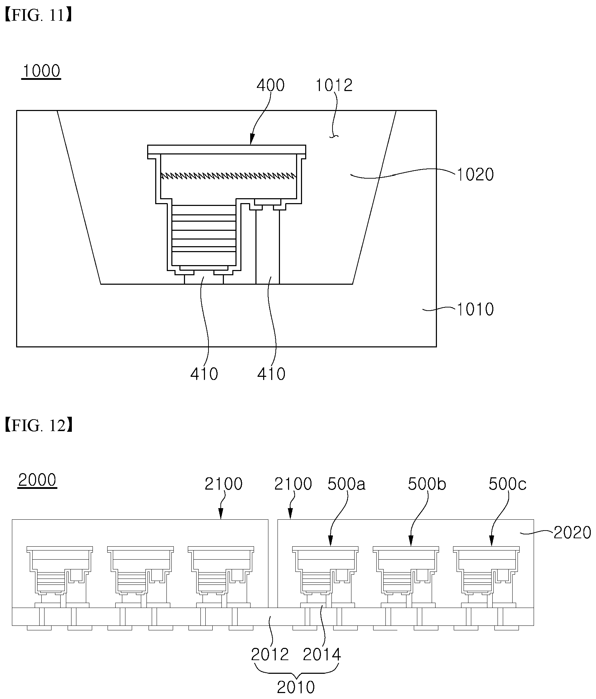

FIG. 11 is a schematic diagram of a light emitting apparatus 1000 according to an embodiment of the disclosed technology. In FIG. 11, the light emitting apparatus 1000 may be a light emitting package.

Referring to FIG. 11, a light emitting package 1000 according to this embodiment may include a housing 1010, a light emitting device 400 and a molding layer 1020.

The housing 1010 has a cavity 1012 with an open upper portion, and the light emitting device 400 may be mounted in the cavity 1012. An inner surface forming the cavity 1012 of the housing 1010 may be formed as an inclined surface as shown in FIG. 11 or may be formed perpendicular to a bottom surface of the cavity 1012. In addition, the inner surface of the cavity 1012 of the housing 1010 may include a material that reflects light from the light emitting device 400 as needed. When the inner surface of the cavity 1012 of the housing 1010 reflects light of the light emitting device 400 upward, a radiation efficiency of the light emitting package 1000 may be improved.

The housing 1010 may be formed of plastic, ABS (acrylonitrile butadiene styrene), LCP (liquid crystalline polymer), PA (polyamide), IPS (polyphenylene sulfide), TPE (thermoplastic elastomer), or others. In addition, the housing 1010 may be formed of metal, ceramic, or the like. In addition, the housing 1010 may include two lead terminals (not shown in the drawings). The lead terminals may be electrically connected to the light emitting device 400 mounted in the cavity 1012 of the housing 1010. In addition to the above configurations, the housing 1010 may include various known configurations as needed.

Referring to FIG. 11, the light emitting device 400 mounted in the cavity 1012 of the housing 1010 may be configured to be identical or similar to the light emitting device (100 of FIG. 1) of the first embodiment. Alternatively, the light emitting device 400 of this embodiment may be configured to be identical or similar to one of the light emitting devices of the second and third embodiments (200 of FIG. 6 or 300 of FIG. 10).

The light emitting package 1000 may include a bump 410 for electrical connection between the light emitting device 400 and the lead terminals of the housing 1010. First electrodes 102, 202, and 302 and second electrodes 104, 204, and 304 of the light emitting device 400 may be electrically connected to the lead terminals of the housing 1010 through the bumps 410 formed thereon, respectively.

The bump 410 may be formed of a conductive material such as metal, solder, or the like. In addition, the bump 410 may be formed of a single layer or a plurality of layers, and when formed of the plurality of layers, at least one layer may be formed of a conductive material different from those of other layers.

Moreover, although FIG. 11 exemplarily illustrates that one light emitting device 400 is mounted in the housing 1010, the inventive concepts are not limited thereto. A plurality of light emitting devices 400 may be mounted in the housing 1010.

The molding layer 1020 may be formed to fill the cavity 1012 of the housing 1010, and may be formed to protect the light emitting device 400.

The molding layer 1020 may be formed of a transparent material through which light emitted from the light emitting device 400 is transmitted. For example, the molding layer 1020 may be formed of a polymer including at least one of a silicone series, an epoxy series, a PMMA (polymethyl methacrylate) series, a PE (polyethylene) series, or a PS (polystyrene) series, and may also be formed of an inorganic material such as glass.

In another embodiment, the light emitting package 1000 may include a wavelength conversion material dispersed in the molding layer 1020. The wavelength conversion material may be excited by light emitted from the light emitting device 400 and emit light of a wavelength different from that of light of the light emitting device 400. For example, the wavelength conversion material may be a quantum dot, a phosphor, or others.

FIG. 12 may be a schematic diagram illustrating a light emitting apparatus 2000 according to the second embodiment of the disclosed technology. The light emitting apparatus 2000 may be a light emitting module.

Referring to FIG. 12, a light emitting module 2000 may include a module substrate 2010 and a plurality of groups 2100 formed on the module substrate 2010. Each of the groups 2100 may include a plurality of light emitting devices 500a, 500b, and 500c and a molding layer 2020 covering the plurality of light emitting devices 500a, 500b, and 500c.

The module substrate 2010 may include a base 2012 and an interconnection 2014 formed on the base 2012 to be electrically connected to the plurality of light emitting devices 500a, 500b, and 500c.

The base 2012 may be formed of an insulation material or may be formed of metal. When the base 2012 is formed of metal, an insulation material may be formed between the base 2012 and the interconnection 2014 to insulate them from each other.

The light emitting module 2000 may control an operation of each of the groups 2100 by supplying electricity to the plurality of light emitting devices 500a, 500b, and 500c through the module substrate 2010.

The plurality of light emitting devices 500a, 500b, and 500c may emit light of a same color, or at least one of them may emit light of a different color. In addition, a number of light emitting devices 500a, 500b, and 500c included in one group 2100 of the light emitting module 2000 may be variously changed.

Referring to FIG. 12, the plurality of light emitting devices 500a, 500b, and 500c may be a first light emitting device 500a, a second light emitting device 500b, and a third light emitting device 500c, respectively. At least one of the first light emitting device 500a, the second light emitting device 500b, and the third light emitting device 500c may emit light of a different color or all may emit light of a same color. For example, the first light emitting device 500a may emit red light, the second light emitting device 500b may emit blue light, and the third light emitting device 500c may emit green light. Alternatively, the first light emitting device 500a may emit red light, the second light emitting device 500b may emit yellow light, and the third light emitting device 500c may emit cyan light.

Alternatively, the first to third light emitting devices 500a, 500b, and 500c may all emit light of a same color. For example, the first to third light emitting devices 500a, 500b, and 500c may all emit red light. In this case, the first light emitting device 500a or the first to third light emitting devices 500a, 500b, and 500c emitting red light may be configured to be identical or similar to one of the light emitting devices of the first to third embodiments described previously (100 of FIG. 1, 200 of FIG. 6, or 300 of FIG. 10).

When the first to third light emitting devices 500a, 500b, and 500c emit light of the same color, a difference between peak wavelengths of light emitted from each of the first to third light emitting devices 500a, 500b, and 500c may be about 5 nm or less.

The first to third light emitting devices (500a, 500b, 500c) may be electrically connected to the interconnection 2014 of the module substrate 2010 through bumps. In addition, the first to third light emitting devices 500a, 500b, and 500c may be individually operated through the module substrate 20110. Therefore, the operation of the first to third light emitting devices 500a, 500b, and 500c of each of the groups 2100 may be controlled to emit light of various colors.

Although it is described in this embodiment that one group 2100 includes the plurality of light emitting devices 500a, 500b, and 500c, one group 2100 may also include a single light emitting device 500a, 500b, or 500c.

The light emitting devices of the first and second embodiments of the disclosed technology (100 in FIG. 1 and 200 in FIG. 6) emit light through the first window layer 110 and 210 doped with an n-type impurity, and have a structure in which a direction of the electrodes is same as that of light emitting devices emitting light of different colors. Therefore, when the light emitting devices of the first embodiment and the second embodiment (100 of FIG. 1 and 200 of FIG. 6) are applied to the first light emitting device 500a, an interconnection design for forming a common electrode with the second and third light emitting devices 500b and 500c that emit different colors of light may be configured easier and simpler.

The molding layer 2020 may be formed over the module substrate 2010, and may be formed to cover the first to third light emitting devices 500a, 500b, and 500c for each of the groups 2100. The molding layer 2020 may be formed of a material that transmits light from the first to third light emitting devices 500a, 500b, and 500c. For example, the molding layer 2020 may be formed of a polymer including at least one of a silicone series, an epoxy series, a PMMA (polymethyl methacrylate) series, a PE (polyethylene) series, or a PS (polystyrene) series, and may also be formed of an inorganic material such as glass.

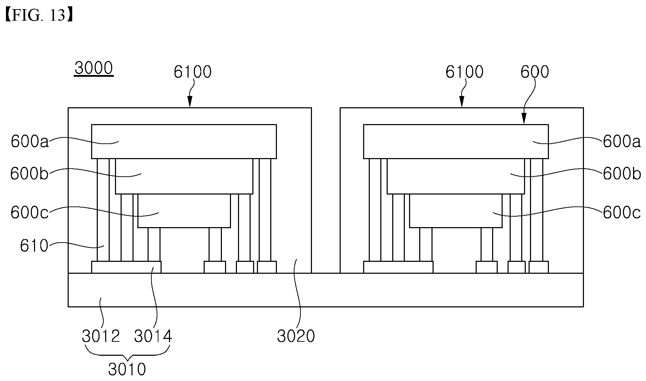

FIG. 13 is a schematic diagram illustrating a light emitting apparatus 3000 according to the third embodiment of the disclosed technology. The light emitting apparatus 3000 may be a light emitting module.

Referring to FIG. 13, a light emitting module 3000 according to the third embodiment may include a module substrate 3010 and a plurality of groups 6100 formed on the module substrate 3010. The module substrate 3010 of this embodiment may also include a base 3012 and an interconnection 3014 formed on the base 3012.

The plurality of groups 6100 may emit light of different colors, or may emit light of a same color. Each of the groups 6100 may include light emitting devices 600a, 600b, and 600c stacked in a vertical direction with respect to each other and a molding layer 3020 formed to cover the light emitting devices 600a, 600b, and 600c.

For example, each of the groups 6100 may include a first light emitting device 600a that emits red light, a second light emitting device 600b that emits blue light, and a third light emitting device 600c that emits green light. In this case, a stacking order may be variously changed. In this embodiment, the first light emitting device 600 emitting red light may be configured to have a same or similar semiconductor layer structure as that of the light emitting device of the first to third embodiments described previously (100 of FIG. 1, 200 of FIG. 6 or 300 of FIG. 10).

Referring to FIG. 13, it is illustrated that a width of the first light emitting device 600a stacked at a bottom is a narrowest, and widths of the second light emitting device 600b and the third light emitting device 600c increase as they go upward. However, the inventive concepts are not limited thereto, and the widths of the first to third light emitting devices 600a, 600b, and 600c may be same, or may have different widths as needed.

As such, the light emitting devices of the first to third embodiments of the disclosed technology (100 of FIG. 1, 200 of FIG. 6, and 300 of FIG. 10) may be applied in various ways to various light emitting devices such as light emitting packages, light emitting modules, display apparatuses, and the like.

Although the disclosed technology has been described above with reference to preferred embodiments, it will be understood by those skilled in the art or having ordinary knowledge in the art that various modifications and changes may be made to the disclosed technology without departing from the spirit and technical scope of the disclosed technology as set forth in the claims below.

Therefore, the technical scope of the disclosed technology should not be limited to the contents described in the detailed description of the specification, but should be defined by the scope of the patent claims.

## Claims

1. A light emitting device, comprising:
a first window layer doped with a first conductivity type dopant, a second window layer doped with a second conductivity type dopant, and an active layer disposed between the first window layer and the second window layer to generate light,
wherein the active layer includes at least two quantum barrier layers, at least one quantum well layer, and an aid layer disposed between the quantum well layer and the quantum barrier layer.

2. The light emitting device of claim 1,
wherein an energy band gap of the aid layer is smaller than that of the quantum barrier layer and larger than that of the quantum well layer.

3. The light emitting device of claim 1, wherein:
the quantum barrier layer and the aid layer include Al and Ga, and
wherein an Al composition of the aid layer is smaller than that of the quantum barrier layer.

4. The light emitting device of claim 3,
wherein a gradient of an Al composition profile in the aid layer is different from that of a Ga composition profile.

5. The light emitting device of claim 3,
wherein a difference between the Al composition of the aid layer and the Al composition of the quantum barrier layer is 10% or more.

6. The light emitting device of claim 3,
wherein the aid layer has variable compositions of Al and Ga from an adjacent quantum well layer to an adjacent quantum barrier layer.

7. The light emitting device of claim 6,
wherein a difference between the Al composition and the Ga composition in the aid layer increases toward the adjacent quantum well layer.

8. The light emitting device of claim 7,
wherein the active layer emits red light.

9. The light emitting device of claim 3,
wherein a difference between an Al composition of the quantum well layer and the Al composition of the aid layer is greater than the difference between the Al composition of the quantum barrier layer and the Al composition of the aid layer.

10. The light emitting device of claim 3, wherein:
the quantum well layer includes Ga, and
a difference between a Ga composition of the quantum well layer and the Ga composition of the aid layer is smaller than a difference between a Ga composition of the quantum barrier layer and the Ga composition of the aid layer.

11. The light emitting device of claim 1, wherein:
the active layer includes a plurality of stacked quantum structures, and
the quantum structure is a structure where the quantum well layer, the aid layer, and the quantum barrier layer are sequentially stacked.

12. The light emitting device of claim 1,
wherein the aid layers are disposed between adjacent each quantum well layer and each quantum barrier layer.

13. The light emitting device of claim 12, wherein:
the active layer includes a plurality of stacked quantum structures, and
the quantum structure is a structure where the aid layer, the quantum well layer, the aid layer, and the quantum barrier layer are sequentially stacked.

14. The light emitting device of claim 1, further comprising:
a first layer disposed between the first window layer and the active layer to prevent holes or electrons from diffusing from the active layer to the first window layer, and a second layer disposed between the second window layer and the active layer to prevent holes or electrons from diffusing from the active layer to the second window layer.

15. The light emitting device of claim 14, further comprising:
a first clad layer disposed between the first window layer and the active layer, and a second clad layer disposed between the second window layer and the active layer.

16. The light emitting device of claim 15, wherein:
the first clad layer is disposed between the first window layer and the first layer, and
the second clad layer is disposed between the second window layer and the second layer.

17. The light emitting device of claim 1, wherein:
one surface of the first window layer is a light exiting surface through which light is emitted, and irregularities are formed on the light exiting surface.

18. The light emitting device of claim 3,
wherein the active layer includes a plurality of intersection points CPs where an Al composition profile and a Ga composition profile intersect.

19. The light emitting device of claim 18,
wherein, with respect to a virtual line L connecting the plurality of intersection points CPs, a vertical distance between the Al composition profile and the virtual line L in the quantum barrier layer is greater than a vertical distance between the Ga composition profile and the virtual line L.

20. The light emitting device of claim 18,
wherein, with respect to the virtual line L connecting the plurality of intersection points CPs, a vertical distance between the Al composition profile and the virtual line L in the quantum well layer is smaller than a vertical distance between the Ga composition profile and the virtual line L.

21. A light emitting device, comprising: a first window layer doped with a first conductivity type dopant; a second window layer doped with a second conductivity type dopant; an active layer disposed between the first window layer and the second window layer to generate light; a first light transmission layer disposed on one side of the first window layer; and a second light transmission layer disposed between the first light transmission layer and the first window layer,
wherein the second light transmission layer includes a void.

22. A light emitting device, comprising: a first window layer doped with a first conductivity type dopant; a second window layer doped with a second conductivity type dopant; and an active layer disposed between the first window layer and the second window layer to generate light,
wherein the first window layer has roughness on at least one of an upper surface and a lower surface.

23. A light emitting device, comprising: a first window layer doped with a first conductivity type dopant; a second window layer doped with a second conductivity type dopant; an active layer disposed between the first window layer and the second window layer to generate light; a first layer disposed between the first window layer and the active layer; and a second layer disposed between the second window layer and the active layer,
wherein the first layer and the second layer have a symmetrical structure with respect to the active layer.

24. A light emitting device, comprising: a first window layer doped with a first conductivity type dopant; a second window layer doped with a second conductivity type dopant; an active layer disposed between the first window layer and the second window layer to generate light; and an intermediate layer disposed between the active layer and the second window layer,
wherein a lattice constant of the intermediate layer has a value between the lattice constants of layers positioned over and under the intermediate layer.

25. A light emitting device, comprising: a first window layer doped with a first conductivity type dopant; a second window layer doped with a second conductivity type dopant; and an active layer disposed between the first window layer and the second window layer to generate light,
wherein, in an emission spectrum of the light, an integral area of a shorter wavelength region with respect to a peak wavelength is larger than an integral area of a longer wavelength region.
